(19) Europäisches Patentamt

European Patent Office

Office européen des brevets

(11) EP 1 289 125 A2

(12) **EUROPEAN PATENT APPLICATION**

(43) Date of publication:
05.03.2003 Bulletin 2003/10

(51) Int Cl.⁷: $H03D\ 7/14$

(21) Application number: 02017770.5

(22) Date of filing: 09.08.2002

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: **10.08.2001 JP 2001244555**

(71) Applicant: **Kabushiki Kaisha Toshiba Tokyo 105-8001 (JP)**

(72) Inventor: **Kano, Nobuo**
**1-1 Shibaura 1-chome Minato-ku Tokyo 105 (JP)**

(74) Representative: **HOFFMANN - EITLE**
**Patent- und Rechtsanwälte**
**Arabellastrasse 4**
**81925 München (DE)**

(54) **Double balance mixer circuit and orthogonal demodulation circuit using the same**

(57) A double balance mixer circuit comprises a first switching pair (22a) to which first and third signals are inputted, a second switching pair (22b) to which second and fourth signals are inputted, pulses of the first to fourth signals rising sequentially during one period, the pulse of the second signal rising at the time when the pulse of the first signal falls, the pulse of the third signal rising at the time when the pulse of the second signal falls, and the pulse of the fourth signal rising at the time when the pulse of the third signal falls, a driving stage (23) which connects to each of the first and second switching pairs (22a, 22b) and to which fifth and sixth signals are inputted, a first load block (21a) which is connected to the first switching pair (22a), and a second load block (21b) which is connected to the second switching pair (22b) .

F I G. 4

EP 1 289 125 A2

## Description

This invention relates to a double balance mixer circuit which obtains a demodulation signal by performing multiplication using carrier signals and reception signals and an orthogonal demodulation circuit using the double balance mixer circuit.

In digital modulation recently used in mobile communications, two baseband signals with a 90° phase difference between them are used in transmission or reception to increase the use efficiency of the frequency. The two baseband signals are known as an I signal and a Q signal. The I and Q signals are modulated in transmission. The modulated I and Q signals are demodulated in receiver. At this time, the receiver side requires a demodulator with a phase shifter that accurately realizes a 90° phase difference between the I and Q signals.

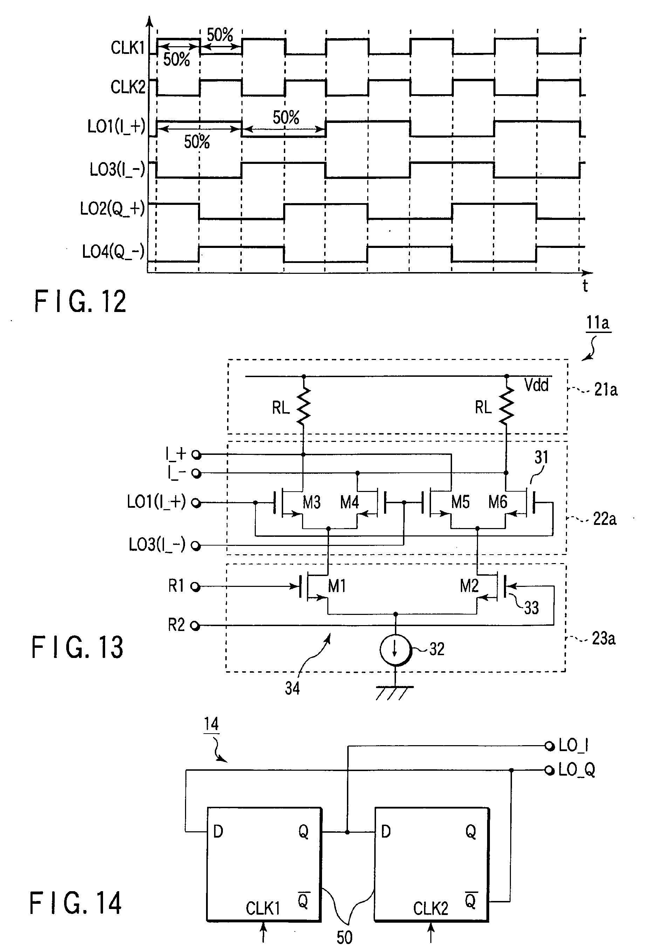

FIG. 11 shows the configuration of a prior-art orthogonal demodulation circuit. FIG. 12 shows operating waveforms of the clock signals and local signals in the prior-art orthogonal demodulation circuit. The configuration and operation of the prior-art orthogonal demodulation circuit will be explained below.

As shown in FIG. 11, the prior-art orthogonal demodulation circuit 10 comprises a first and a second double balance mixer (DBM) circuit 11a, 11b, and a phase shifter 12. The phase shifter 12 is composed of a local buffer 13 and a 90° phase shifter 14.

In such an orthogonal demodulation circuit 10, when a sinusoidal wave signal whose frequency is twice the frequency of the local signal is inputted to the local buffer 13, the local buffer 13 outputs clock signals CLK1, CLK2. Passing these clock signals CLK1, CLK2 through the 90° phase shifter 14 causes local signals LO1, L02, L03, L04 with a 90° phase difference between them to be outputted. Then, the local signals LO1, L03 are inputted to the first double balance mixer circuit 11a. The local signals L02, L04 are inputted to the second double balance mixer circuit 11b. On the other hand, reception signals R1, R2 obtained by demodulating signals in high-frequency or intermediate-frequency bands are inputted to the first and second double balance mixer circuits 11a, 11b. The first and second double mixer circuits 11a, 11b perform the multiplication of the received signals and local signals, thereby producing I-channel and Q-channel demodulation signals. A first and a second gain control signal GC1, CG2 are inputted to the first and second double balance mixer circuits 11a, 11b, respectively, thereby controlling the gains of the I channel and Q channel.

To obtain the local signals LO1, L02, L03, L04 with a 90° phase difference between them, a source signal whose frequency is twice the desired frequency of the local signals LO1, L02, L03, L04 is required. That is, as shown in FIG. 12, the clock signals CLK1, CLK2 have twice the frequency of the local signals LO1, L02, L03, L04. The waveforms of the clock signals CLK1, CLK2 and local signals LO1, L02, L03, L04 are rectangular waves with a duty ratio of 50%.

FIG. 13 shows the configuration of a prior-art double balance mixer circuit. As shown in FIG. 13, a first double balance mixer 11a in an orthogonal demodulation circuit 10 comprises a load block 21a, a switching pair 22a, and a driving stage 23a. The switching pair 22a has a switching element 31 composed of transistors M3, M4, M5, M6. The driving stage 23a has a differential pair circuit 34 composed of a current source 32 and a transistor 33. For example, the local signals LO1, L03 whose amplitude fluctuates between the power supply voltage and the ground at the same frequency as the carrier frequency are inputted to the switching pair 22a, which causes the switching pair 22a to perform a switching operation. In FIG. 13, the first double balance mixer circuit 11a has been explained. The second double balance mixer circuit 11b has the same configuration. The double balance mixer circuits 11a, 11b may be used in a modulator.

The operation of the double balance mixer circuit 11a is expressed by the following equation (1):

$$\cos\omega_s t \cos\omega_c t$$

$$= 1/2 \{\cos(\omega_s t + \omega_c t) + \cos(\omega_s t - \omega_c t)\} \qquad (1)$$

where $\omega_s$ represents the frequency component of the reception signal and $\omega_c$ represents the frequency component of the local signal.

The frequency component of the reception signal and the frequency component of the local signal are inputted to R1, R2 and LO1, L03, respectively, in FIG. 13. At this time, the difference component between the frequency component of the reception signal and the frequency component of the local signal is obtained by a filter at the output of the double balance mixer circuit 11a, thereby producing a demodulation signal composed of I and Q signals.

FIG. 14 shows the configuration of a prior-art 90° phase shifter. As shown in FIG. 14, the 90° phase shifter, which is an important component element of the orthogonal demodulation circuit 10, is composed of a counter 50 using, for example, D flip-flops. The clock signals CLK1, CLK2 from the local buffer 13 are inputted to the counter 50, which outputs local signals LO with a 90° phase difference between them. When a digital phase shifter as shown in FIG. 14 is used as the 90° phase shifter, it is easy to obtain local signals LO with an accurate 90° difference shift between them.

The prior-art orthogonal demodulation circuit 10 has the following two problems.

A first problem is that phase errors occur in the local signals LO1, L02, L03, and L04. That is, since a differential amplifier is used in the local buffer 13 that shapes a sinusoidal wave signal into a pulse waveform, it is difficult to make the offset component of the local buffer 13 completely zero. For this reason, the offset component of the local buffer 13 prevents the duty ratio of the pulse waveforms of the clock signals CLK1, CLK2 from being kept at 50%. If the clock signals CLK1, CLK2 that have pulse waveforms with a 50% duty ratio are not inputted to the 90° phase shifter 14, phase errors occur between the local signals LO1, L03 of the I channel and the local signals L02, L04 of the Q channel.

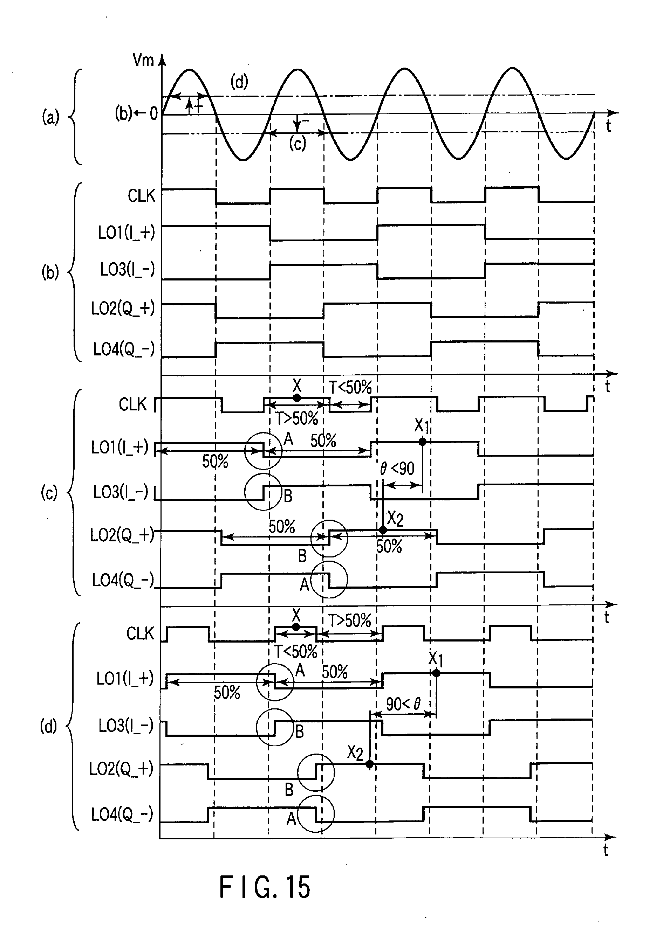

The phase error problem will be explained concretely by reference to FIG. 15. In FIG. 15, portion (a) shows a waveform diagram of a sinusoidal wave signal inputted to the local buffer. Portion (b), portion (c), and portion (d) show waveforms of local signals inputted to the double balance mixer circuit.

When there is no offset component in the local buffer 13, the ground level of the sinusoidal wave signal remains unchanged as shown in portion (a) of FIG. 15. Therefore, the clock waveform of the clock signal CLK is a rectangular waveform with a duty ratio of 50% as shown in portion (b) of FIG. 15. As a result, each of the waveforms of the first, second, third, and fourth local signals LO1, L02, L03, and L04 has a duty ratio of 50%.

In a case where there is an offset component in the local buffer 13 and the ground level of the sinusoidal wave signal shifts to the negative side as shown in portion (a) of FIG. 15, the pulse width widens from the center X of a high-level pulse toward the ends of both sides in a clock waveform of the clock signal CLK as shown in portion (c) of FIG. 15, with the result that the duty ratio of the high level is 50% or more. Consequently, the position of the rising portion A of a pulse of each of the first and fourth local signals LO1, L04 and the position of the rising portion B of a pulse of each of the second and third local signals L02, L03 change. As a result, the phase difference between the center $X_1$ of the high-level pulse of the first local signal LO1 and the center $X_2$ of the high-level pulse of the second local signal L02 is 90° or less.

In a case where there is an offset component in the local buffer 13 and the ground level of the sinusoidal wave signal shifts to the positive side as shown in portion (a) of FIG. 15, the pulse width narrows from the center X of a high-level pulse to the ends of both sides in a clock waveform of the clock signal CLK as shown in portion (d) of FIG. 15, with the result that the duty ratio of the high level is 50% or less. Consequently, the position of the falling portion A of a pulse of each of the first and fourth local signals LO1, L04 and the position of the falling portion B of a pulse of each of the second and third local signals L02, L03 change. As a result, the phase difference between the center $X_1$ of the high-level pulse of the first local signal LO1 and the center $X_2$ of the high-level pulse of the second local signal L02 is 90° or more.

The cases where there is an offset component in the local buffer 13 have been explained as examples. When the duty ratio of the clock waveform cannot be kept at 50% due to other factors, a phase difference of 90° cannot be kept between the local signals of the I channel and Q channel.

A second problem is that there arises a gain error between the I and Q signals in providing the orthogonal demodulation circuit 10 with a variable gain function. The gain of the orthogonal demodulation circuit 10 can be varied by varying the bias current of the driving stage 23a in each of the double balance mixer circuits 11a, 11b. Normally, in a receiver, to vary the gain in decibel representation for the gain control signals GC1, GC2, exponential function output currents for the control voltage are used as the gain control signals GC1, GC2. At this time, since the orthogonal demodulation circuit 10 has two double balance mixer circuits 11a, 11b for the I and Q channels, it needs two gain control signals GC1, GC2 for the double balance mixer circuits 11a, 11b. If the gain control signals GC1, GC2 to vary the gain, or the variations of gain, in the I signal differ from those in the Q signal, an error occurs between the gain of the I signal and the gain of the Q signal.

As described above, in the prior art, when the duty ratio of the clock waveform inputted to cause the 90° phase shifter to operate cannot be kept. at 50%, the first problem arises: a shift occurs in the 90° phase difference between the local signals. Since use of two double balance mixer circuits 11a, 11b for the I and Q channels requires two gain control signals GC1, GC2, an error occurs between the two gain control signals GC1, GC2, which causes the second problem: the gain and the variation of gain in the I signal differ from those in the Q signal. Therefore, in the prior-art orthogonal demodulation circuit, demodulation errors are caused by the two problems.

According to a first aspect of the present invention, there is provided a double balance mixer circuit comprising: a first switching pair to which a first signal and a third signal are inputted; a second switching pair to which a second signal and a fourth signal are inputted, pulses of the first to fourth signals rising sequentially during one period, the pulse of the second signal rising at the time when the pulse of the first signal falls, the pulse of the third signal rising at the time when the pulse of the second signal falls, and the pulse of the fourth signal rising at the time when the pulse of the third signal falls; a driving stage which connects to each of the first and second switching pairs and to which a fifth signal and a sixth signal are inputted; a first load block which is connected to the first switching pair and which outputs a seventh signal at the junction point of the first load block and the first switching pair, the seventh signal being derived from the multiplication of the first and third signals and the fifth and sixth signals; and a second load block which is connected to the second switching pair and which outputs an eighth signal at the junction point of the second load block and the second switching pair, the eighth signal being derived from the multiplication of the second and fourth signals and the fifth and sixth signals.

According to a second aspect of the present invention, there is provided an orthogonal demodulation circuit comprising: a phase shifter which outputs a first signal, a second signal, a third signal, and a fourth signal; and a double balance mixer circuit which is connected to the phase shifter and takes in the first, second, third, and fourth signals and a fifth signal and a sixth signal and outputs a seventh signal and an eighth signal and which includes a first switching pair to which the first and third signals are inputted, a second switching pair to which the second and fourth signals are inputted, pulses of the first to fourth signals rising sequentially during one period, the pulse of the second signal rising at the time when the pulse of the first signal falls, the pulse of the third signal rising at the time when the pulse of the second signal falls, and the pulse of the fourth signal rising at the time when the pulse of the third signal falls, a driving stage which connects to each of the first and second switching pairs and to which the fifth and sixth signals are inputted, a first load block which is connected to the first switching pair and which outputs the seventh signal at the junction point of the first load block and the first switching pair, the seventh signal being derived from the multiplication of the first and third signals and the fifth and sixth signals, and a second load block which is connected to the second switching pair and which outputs the eighth signal at the junction point of the second load block and the second switching pair, the eighth signal being derived from the multiplication of the second and fourth signals and the fifth and sixth signals.

This summary of the invention does not necessarily describe all necessary features so that the invention may also be a sub-combination of these described features.

The invention can be more fully understood from the following detailed description when taken in conjunction with the accompanying drawings, in which:

FIG. 1 shows the configuration of an orthogonal demodulation circuit according to an embodiment of the present invention;
FIG. 2 is a diagram to help explain the operation of a phase shifter used in the orthogonal demodulation circuit of the embodiment;
FIG. 3 shows waveforms related to the embodiment, portion (a) being a waveform diagram of a sinusoidal wave signal, portion (b) being a waveform diagram of a clock signal and local signals, and portion (c) and portion (d) being waveform diagrams of local signals when the duty ratio of the clock signal changes;
FIG. 4 shows the configuration of a double balance mixer circuit according to the embodiment;
FIG. 5 shows the configuration of a switching pair used in the double balance mixer circuit of the embodiment;

FIG. 6 shows the configuration of a driving stage used in the double balance mixer circuit of the embodiment;
FIGS. 7A and 7B are diagrams to help explain the operation of the double balance mixer circuit related to the embodiment;
FIG. 8 is a circuit diagram of a concrete example of the double balance mixer circuit according to the embodiment;
FIG. 9 is a circuit diagram of a concrete example of the phase shifter according to the embodiment;
FIG. 10 is a circuit diagram of a concrete example of an output buffer according to the embodiment;
FIG. 11 shows the configuration of a prior-art orthogonal demodulation circuit;
FIG. 12 is a diagram to help explain the operation of the phase shifter used in the prior-art orthogonal demodulation circuit;
FIG. 13 shows the configuration of a prior-art double balance mixer circuit;
FIG. 14 shows the configuration of a prior-art 90° phase shifter; and
FIG. 15 shows waveforms in the prior art, portion (a) being a waveform diagram of a sinusoidal wave signal, portion (b) being a waveform diagram of a clock signal and local signals, and portion (c) and portion (d) being waveform diagrams of local signals when the duty ratio of the clock signal changes.

Referring to the accompanying drawings, an embodiment of the present invention will be explained. In the explanation below, like parts are indicated by corresponding reference numerals throughout the drawings.

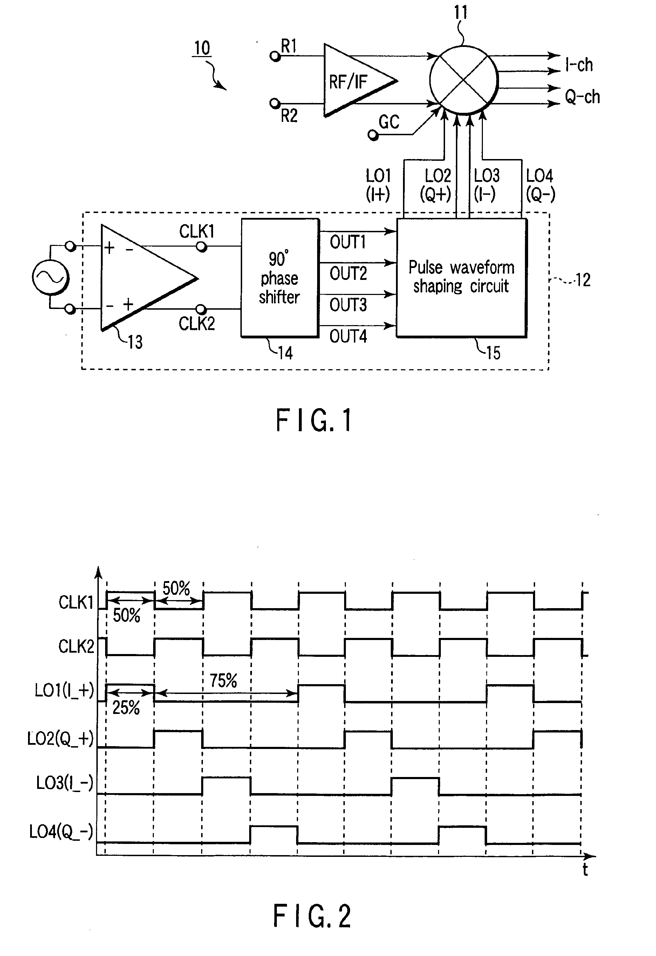

FIG. 1 shows the configuration of an orthogonal demodulation circuit according to an embodiment of the present invention. FIG. 2 shows operating waveforms of the clock signals and local signals in the orthogonal demodulation circuit of the embodiment. Hereinafter, the configuration and operation of the orthogonal demodulation circuit 10 of the embodiment will be explained.

As shown in FIG. 1, the orthogonal demodulation circuit 10 of the embodiment comprises a double balance mixer (DBM) circuit 11 and a phase shifter 12. The phase shifter 12 is composed of a local buffer 13, a 90° phase shifter 14, and a pulse waveform shaping circuit 15.

In the orthogonal demodulation circuit 10, when a sinusoidal wave signal whose frequency is twice that of the local signal is inputted to the local buffer 13, the local buffer 13 outputs clock signals CLK1, CLK2. These clock signals CLK1, CLK2 are passed through the 90° phase shifter 14 and pulse waveform shaping circuit 15, which produces local signals LO1, L02, L03, L04. These local signals LO1, L02, L03, L04 are inputted to the double balance mixer circuit 11. On the other hand, received signals R1, R2 obtained by modulating signals in a high-frequency band or intermediate-frequency band are inputted to the double balance mixer circuit 11. Then, the double balance mixer circuit 11 performs the multiplication of the received signals and the local signals, thereby producing I channel and Q channel demodulation signals. In addition, a gain control signal GC is inputted to the double balance mixer circuit 11, thereby controlling the gains of the I channel and the Q channel.

As shown in FIG. 2, clock waveforms of the clock signals CLK1, CLK2 are rectangular with a duty ratio of 50%. The local signals LO1, L02, LO3, and L04 take four phase signal waveforms in sequence in such a manner that the high-level states of the four phase waveforms do not overlap with each other during one period. That is, during one period, a pulse of a second local signal L02 rises at the time when a pulse of a first local signal LO1 falls; a pulse of a third local signal LO3 rises at the time when the pulse of the second local signal L02 falls; and a pulse of a fourth local signal L04 rises at the time. when a pulse of the third local signal LO3 falls. In the local signals LO1, L02, LO3, L04, the duty ratio of the high-level pulse is 25%. The local signals LO1, L02, LO3, L04 have a 90° phase shift between them. The sinusoidal wave signal inputted to the local buffer 13 is shaped into a clock waveform with an amplitude of 1 or 0 using the ground level as a threshold value.

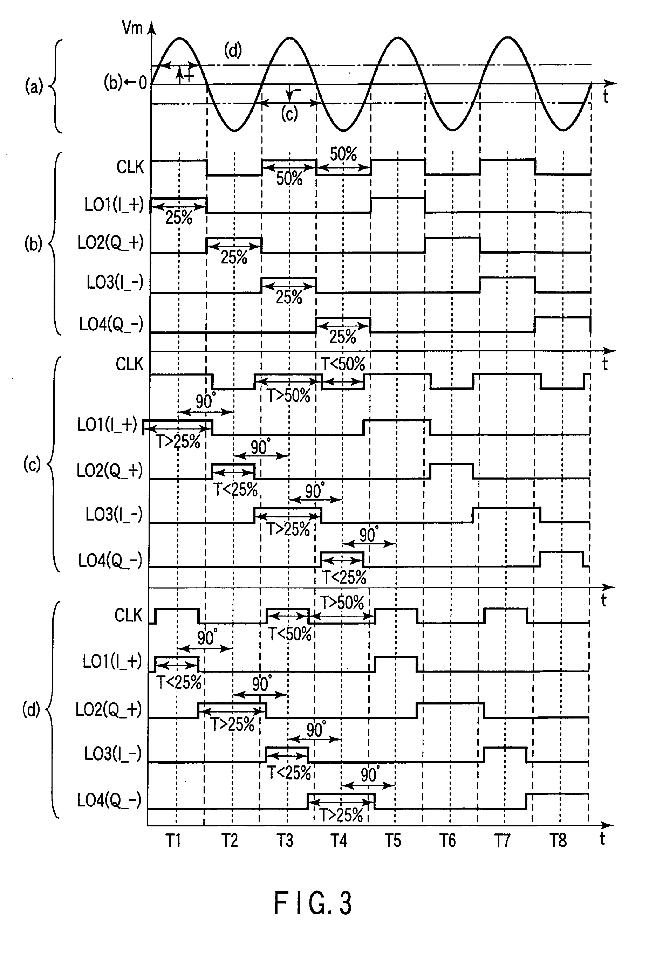

FIG. 3 shows waveforms of a sinusoidal wave signal inputted to the local buffer of the embodiment. Portion (b), portion (c), and portion (d) in FIG. 3 show waveforms of local signals inputted to the double balance mixer circuit of the first embodiment. Hereinafter, how the waveforms of the local signals change when an offset component enters the local buffer 13 will be explained concretely. Even when an offset component exists outside the local buffer 13, the local signals change in a similar manner.

When there is no offset component in the local buffer 13, the ground level of the sinusoidal wave signal remains unchanged as shown in portion (a) of FIG. 3. Therefore, the clock waveform of the clock signal CLK is a rectangular waveform with a duty ratio of 50%. As a result, each of the waveforms of the first, second, third, and fourth local signals LO1, L02, LO3, and L04 has a duty ratio of 25%.

In a case where there is an offset component in the local buffer 13 and the ground level of the sinusoidal wave signal shifts to the negative side as shown in portion (a) of FIG. 3, the width of a high-level pulse in the clock waveform of the clock signal CLK widens as shown in portion (c) of FIG. 3, with the result that the duty ratio of the high level is 50% or more. Consequently, in the first and third local signals LO1, L03, the width of a high-level pulse widens to the same width of the high-level pulse of the clock waveform, with the result that the duty ratio of the high level becomes 25% or more. On the other hand, in the second and fourth local signals L02, L04, the width of a high-level pulse narrows to the same width of the low-level pulse of the clock waveform, with the result that the duty ratio of the high level becomes 25% or less.

In a case where there is an offset component in the local buffer 13 and the ground level of the sinusoidal wave signal shifts to the positive side as shown in portion (a) of FIG. 3, the width of a high-level pulse in the clock waveform of the clock signal CLK narrows as shown in portion (d) of FIG. 3, with the result that the duty ratio of the high level is 50% or less. Consequently, in the first and third local signals LO1, L03, the width of a high-level pulse narrows to the same width of the high-level pulse of the clock waveform, with the result that the duty ratio of the high level becomes 25% or less. On the other hand, in the second and fourth local signals L02, L04, the width of a high-level pulse widens to the same width of the low-level pulse of the clock waveform, with the result that the duty ratio of the high level becomes 25% or more.

As described above, when an offset component exists in the local buffer 13, the duty ratio of the pulse in the clock signal CLK cannot be kept at 50%. In such a case, the pulse width changes in the first to fourth waveforms of the local signals LO1, L02, LO3, L04, including the components changing on the time axis in the opposite direction to the direction in which time elapses, with the result that the duty ratio changes. The first to fourth waveforms of the local signals LO1, LO2, L03, L04 widen or narrow with the centers T1, T2, T3, T4 of the respective high-level pulses as axes. At this time, the pulse width of the waveform of the first local signal LO1 changes in the opposite manner to that of the waveform of the second local signal L02. Alternatively, the pulse width of the waveform of the third local signal L03 changes in the opposite direction to that of the waveform of the fourth local signal L04. Even in such a case, the phase difference between T1 and T2, between T2 and T3, and between T3 and T4 is kept at 90°.

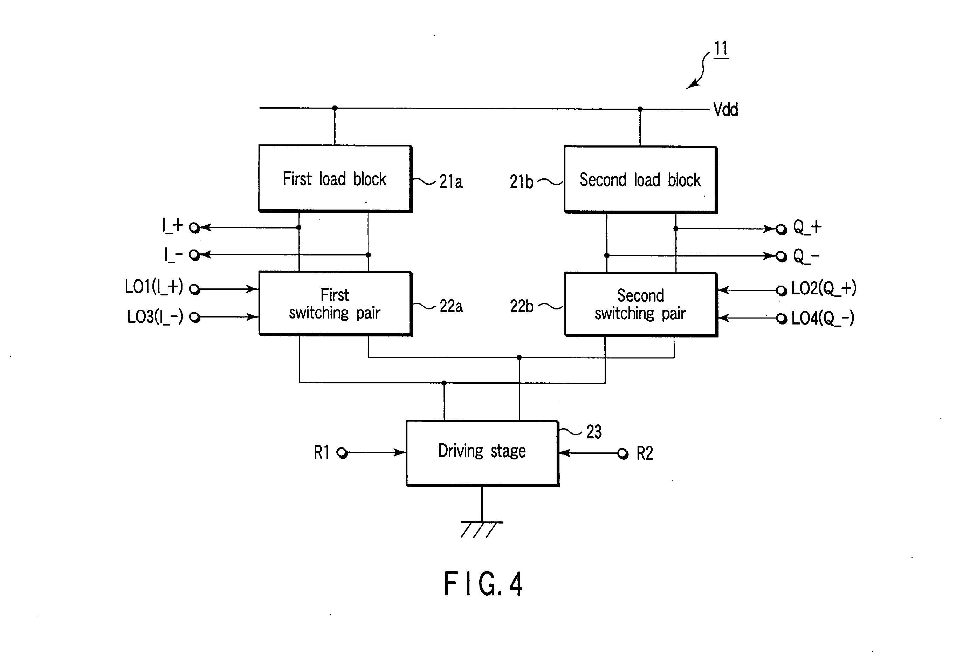

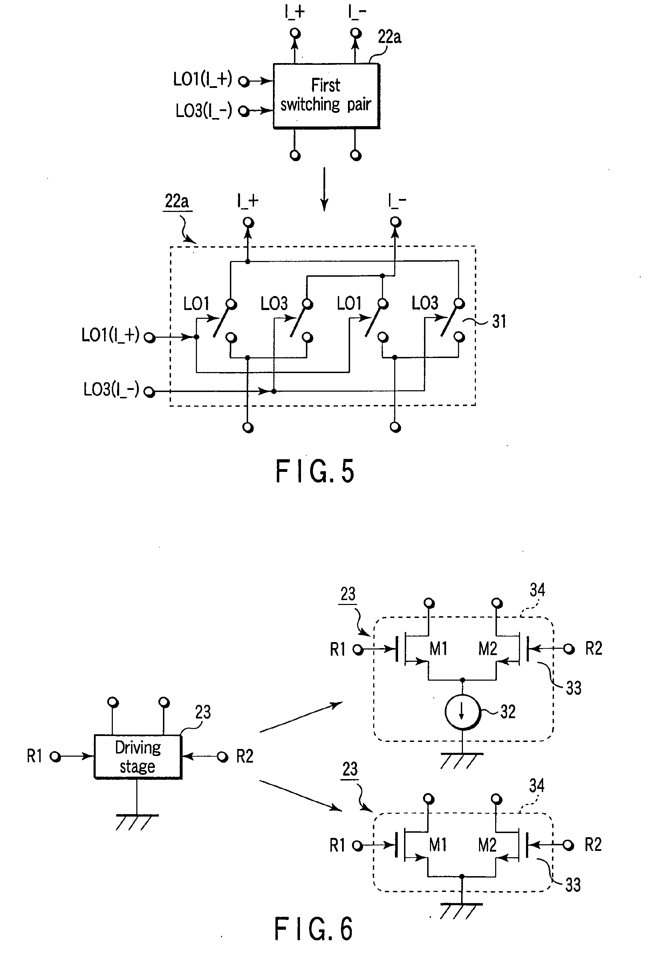

FIG. 4 shows the configuration of a double balance mixer circuit according to the embodiment. FIG. 5 shows the configuration of a switching pair in the double balance mixer circuit of the embodiment. FIG. 6 shows the configuration of a driving stage in the double balance mixer circuit of the embodiment. Hereinafter, the configuration and operation of the double balance mixer circuit of the embodiment will be explained.

As shown in FIG. 4, the double balance mixer circuit 11 comprises a first and a second load block 21a, 21b, a first and a second switching pair 22a, 22b, and a driving stage 23.

The first and second load blocks 21a, 21b are composed of passive elements and such active elements as PMOS transistors. The passive elements are formed by connecting resistors and capacitors in parallel that provide resistance and a time constant.

As shown in FIG. 5, the first switching pair 22a is composed of switching elements 31. Local signals LO1, L03 are inputted to the switching elements 31. The second switching pair 22b has the same configuration as that of FIG. 5.

The driving stage 23 may be composed of a differential pair 34 made up of a current source 32 and transistors 33 as shown in FIG. 6. Alternatively, the driving stage 23 may be composed of a differential pair 34 made up of only transistors 33 with no current source 32, provided that complete differential signals are received as reception signals R1, R2.

Either bipolar transistors or MOS transistors may be used as the switching elements 31 in the switching pairs 22a, 22b and as the transistors 33 in the driving stage 23. The double balance mixer circuit 11 may be used in the modulator.

In such a double balance mixer circuit 11, local signals LO1, L03 are inputted to the first switching pair 22a. Local signals L02, L04 are inputted to the second switching pair 22b. On the other hand, the reception signals R1, R2 are inputted to the driving stage 23. Then, the double balance mixer circuit 11 performs the multiplication of the reception signals and the local signals, with the result that I channel demodulation signals and Q channel demodulation signals are outputted at the junction points between the first and second switching pairs 22a, 22b and the first and second load blocks 21a, 21b.

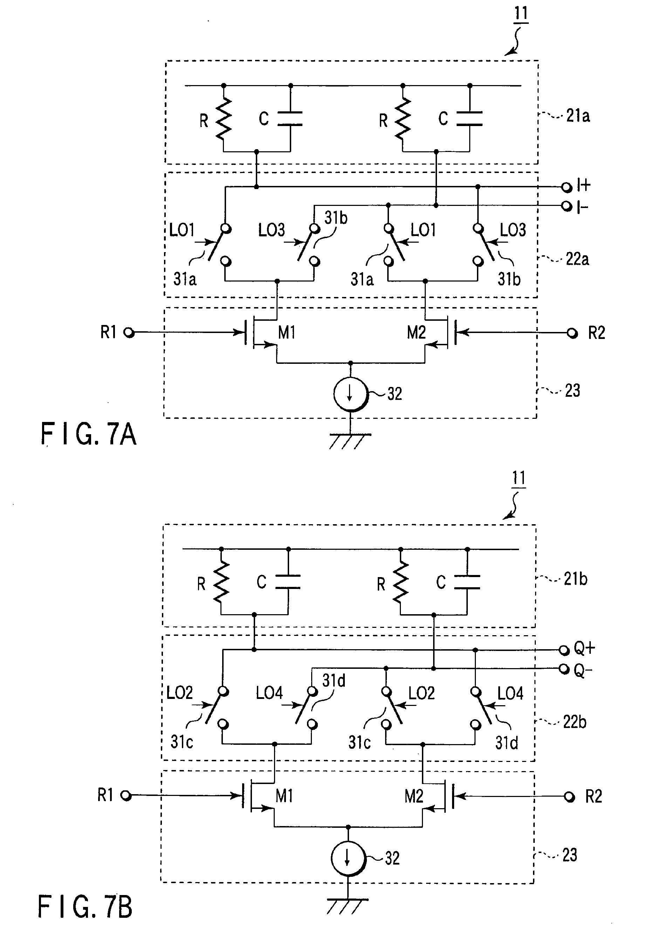

FIGS. 7A and 7B show operation diagrams of the double balance mixer circuit in each phase of the local signals. Hereinafter, the demodulation of the I signal and Q signal in the double balance mixer circuit will be explained.

As shown in FIG. 7A, to demodulate the I signal, the first switching element 31a of the switching pair 22a is turned on, thereby outputting the demodulation signal of the local signal LO1. The second switching element 31b of the switching pair 22a is turned on, thereby outputting the demodulation signal of the local signal LO3.

As shown in FIG. 7B, to demodulate the Q signal, the third switching element 31c of the switching pair 22b is turned on, thereby outputting the demodulation signal of the local signal L02. The fourth switching element 31d of the switching pair 22b is turned on, thereby outputting the demodulation signal of the local signal L04.

At this time, the phases of the high levels of the local signals LO1 to L04 do not overlap with each other as shown in FIG. 2, which prevents both the I and Q signal currents from flowing at the same time in the driving stage 23 during one period of the waveform of local signals LO1 to L04. Therefore, there is no need to provide a driving stage 23 for each of the I channel and Q channel, which reduces the number of driving stages 23 to only one.

Use of an external signal made up of a gain control signal GC to control the bias current of the driving stage 23 causes the gain of the double balance mixer circuit 11 to change, thereby varying the conversion gain of the orthogonal demodulation circuit 10. Since there is only one driving stage 23 in the double balance mixer circuit 11 that changes the gain, only one gain control signal GC is needed for two channels between the I and Q signals.

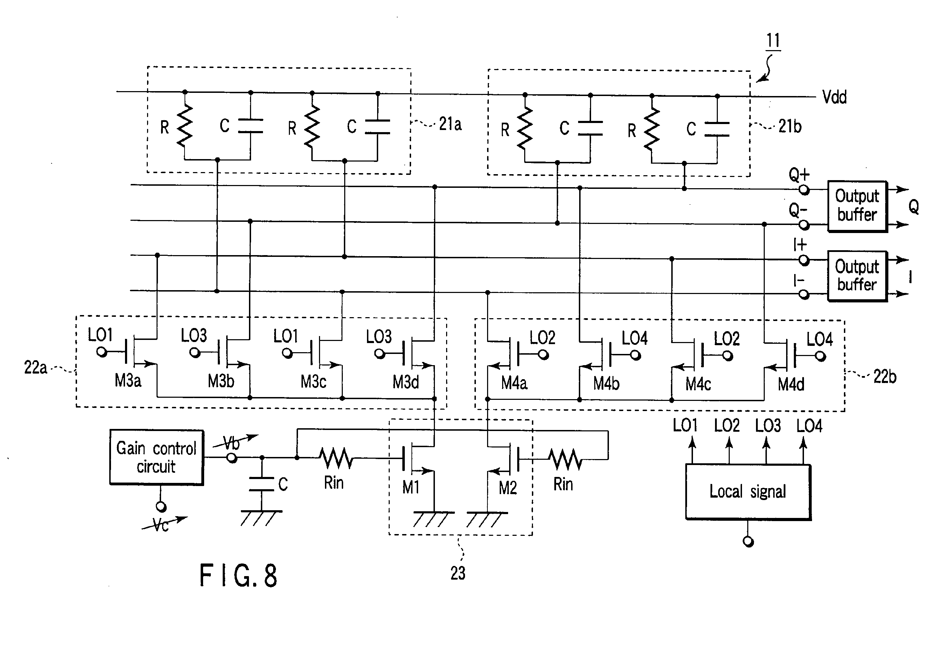

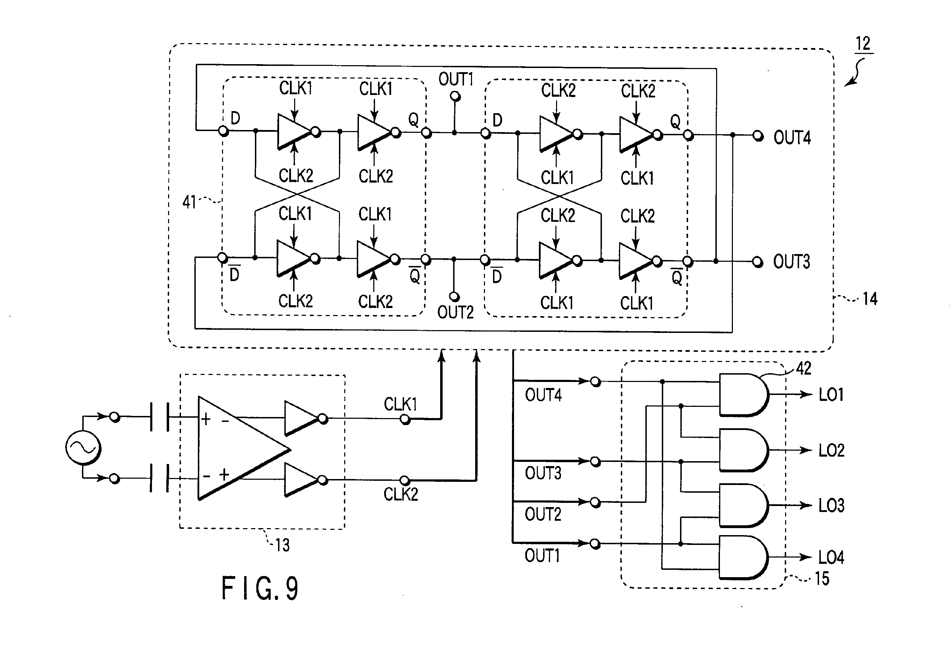

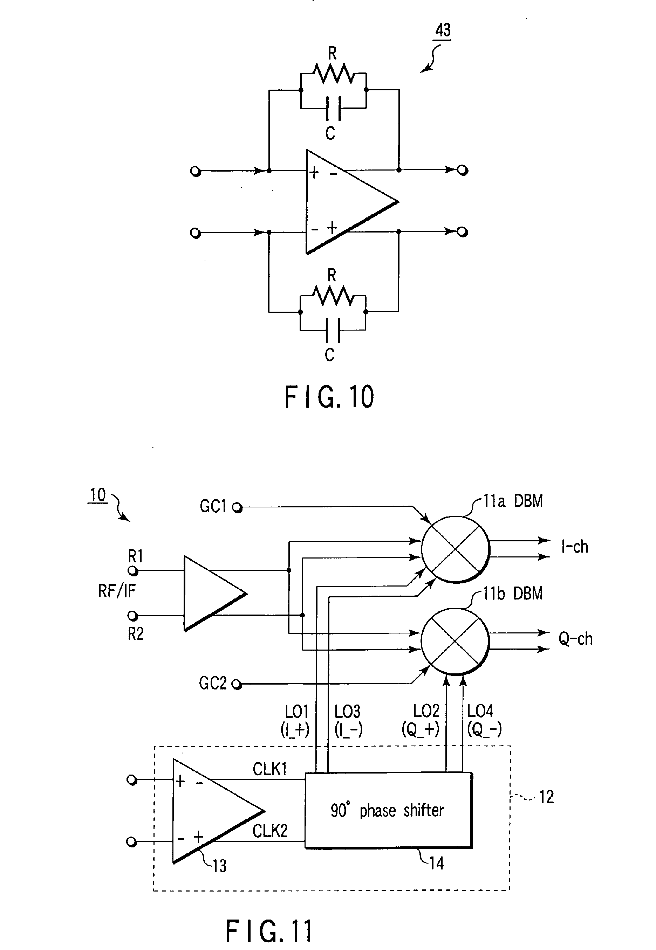

FIG. 8 shows the configuration of the double balance mixer circuit of the embodiment. FIG. 9 shows the configuration of the phase shifter for producing four phase local signals related to the embodiment. FIG. 10 shows the configuration of a circuit provided at the output of the double balance mixer circuit of the embodiment. Hereinafter, a concrete configuration of the orthogonal demodulation circuit related to the embodiment will be explained.

As shown in FIG. 8, the double balance mixer circuit 11 comprises a first and a second load block 21a, 21b, a first and a second switching pair 22a, 22b, and a driving stage 23. The driving stage 23 is composed of MOS transistors M1, M2. The switching pairs 22a, 22b are composed of MOS transistors M3, M4. One end of an input resistance Rin is connected to the gate terminal of each of the MOS transistors M1, M2. One end of a capacitance C is connected to the other end of the input resistance Rin. The other end of the capacitance C is grounded. Controlling a voltage of Vb at the other end of the input resistance Rin by a gain control circuit enables the transconductances of the MOS transistors M1, M2 to be varied. At this time, when a circuit is used which, under the control of an external control voltage Vc, generates such a voltage Vb as causes the drain currents of the MOS transistors M1, M2 to change exponentially, the variation of the gain in decibel representation with respect to the control voltage Vc can be realized. Furthermore, when the amplitudes of the local signals LO1, LO2, L03, L04 are set to values between the power supply and the ground, the MOS transistors M3, M4 of the switching pairs 22a, 22b perform switching operations.

As shown in FIG. 9, the phase shifter 12 is composed of a local buffer 13, a 90° phase shifter 14, and a pulse waveform shaping circuit 15. The 90° phase shifter 14 is composed of a 1/2 frequency demultiplier circuit using D flip-flops. The pulse waveform shaping circuit 15 is composed of AND circuits 42. In the phase shifter 12, signals whose frequency is twice that of the local signals LO1, L02, L03, LO4 are inputted to the local buffer 13. The local buffer 13 then outputs clock signals CLK1, CLK2. The clock signals CLK1, CLK2 are inputted to the 90° phase shifter 14, which uses the 1/2 frequency demultiplier circuit 41 to output four phase signals with a 90° phase difference between them. These signals are passed through the pulse waveform shaping circuit 15, thereby outputting local signals LO1, L02, L03, and L04.

As shown in FIG. 10, since the double balance mixer circuit 11 normally outputs current, a transimpedance circuit 43 is provided at the output of the double balance mixer circuit 11. A parallel connection of a resistance R and a capacitance C is used as the load of the transimpedance circuit 43. The transimpedance circuit 43 performs band limitation, thereby cutting the high-frequency component in the orthogonal demodulation circuit 10.

According to the embodiment, the local signals LO1, L02, L03, and L04 are outputted sequentially in the form of four phase signal waveforms. The four phase waveforms do not overlap with each other in their high-level state. Therefore, even when the duty ratio of each of the clock signals LO1, L02 cannot be kept at 50% because, for example, there is an offset component in the local buffer 3, the interval between the centers of the pulse widths of the local signals LO1, L02, L03, L04 is kept at 90°. Therefore, using the local signals LO1, L02, L03, L04 of the present invention as carrier signals enables phase errors in the orthogonal demodulation circuit 10 to be decreased.

Since the pulse inputs of the local signals LO1, L02, L03, L04 do not overlap with each other even when the double balance mixer circuit 11 is composed of the single driving stage 23, it is possible to demodulate two I and Q signals that keep a 90° phase difference from the received signals. Therefore, when the gains of two I and Q channels are varied simultaneously, there is no need to use two double balance mixer circuits 11 or two gain control signals GC. Consequently, when the gains of the I and Q signals are varied, variations in the gains and errors in the gains can be reduced.

As described above, according to the embodiment, phase errors and gain errors can be reduced and therefore modulation errors in the orthogonal demodulation circuit can be reduced.

**Claims**

1. A double balance mixer circuit **characterized by** comprising:

   a first switching pair (22a) to which a first signal and a third signal are inputted;
   a second switching pair (22b) to which a second signal and a fourth signal are inputted, pulses of said first to fourth signals rising sequentially during one period, the pulse of said second signal rising at the time when the pulse of said first signal falls, the pulse of said third signal rising at the time when the pulse of said second signal falls, and the pulse of said fourth signal rising at the time when the pulse of said third signal falls;
   a driving stage (23) which connects to each of said first and second switching pairs (22a, 22b) and to which a fifth signal and a sixth signal are inputted;
   a first load block (21a) which is connected to said first switching pair (22a) and which outputs a seventh signal at the junction point of the first load block (21a) and said first switching pair (22a), the seventh signal being derived from the multiplication of said first and third signals and said fifth and sixth signals; and
a second load block (21b) which is connected to said second switching pair (22b) and which outputs an eighth signal at the junction point of the second load block (21b) and said second switching pair (22b), the eighth signal being derived from the multiplication of said second and fourth signals and said fifth and sixth signals.

2. The double balance mixer circuit according to claim 1, **characterized in that** said driving stage (23) takes in a ninth signal and controls the ninth signal to vary the gains of said seventh and eighth signals.

3. The double balance mixer circuit according to claim 1, **characterized in that** said driving stage (23) comprises a differential pair (34) including two transistors (33).

4. The double balance mixer circuit according to claim 1, **characterized in that** said driving stage (23) comprises a differential pair (34) including two transistors (33) and a current source (32).

5. The double balance mixer circuit according to claim 1, **characterized in that** said driving stage (23) and said first and second switching pairs (22a, 22b) include bipolar transistors or MOS transistors.

6. The double balance mixer circuit according to claim 1, **characterized in that** said first and second load blocks (21a, 21b) include passive elements or active elements.

7. The double balance mixer circuit according to claim 1, **characterized in that** the pulse width of a waveform of said first signal changes in the opposite manner to the pulse width of a waveform of said second signal, or the pulse width of a waveform of said third signal changes in the opposite manner to the pulse width of a waveform of said fourth signal.

8. The double balance mixer circuit according to claim 1, **characterized in that**, if the centers of high-level pulses of said first, second, third, and fourth signals are T1, T2, T3, and T4, respectively, the phase difference between T1 and T2, the phase difference between T2 and T3, and the phase difference between T3 and T4 are kept at 90°.

9. An orthogonal demodulation circuit **characterized by** comprising:

a phase shifter (12) which outputs a first signal, a second signal, a third signal, and a fourth signal; and

a double balance mixer circuit (11) which is connected to said phase shifter (12) and takes in said first, second, third, and fourth signals and a fifth signal and a sixth signal and outputs a seventh signal and an eighth signal and which includes

a first switching pair (22a) to which the first and third signals are inputted,

a second switching pair (22b) to which the second and fourth signals are inputted, pulses of said first to fourth signals rising sequentially during one period, the pulse of said second signal rising at the time when the pulse of said first signal falls, the pulse of said third signal rising at the time when the pulse of said second signal falls, and the pulse of said fourth signal rising at the time when the pulse of said third signal falls,

a driving stage (23) which connects to each of said first and second switching pairs (22a, 22b) and to which the fifth and sixth signals are inputted,

a first load block (21a) which is connected to said first switching pair (22a) and which outputs the seventh signal at the junction point of the first load block (21a) and said first switching pair (22a), the seventh signal being derived from the multiplication of said first and third signals and said fifth and sixth signals, and

a second load block (21b) which is connected to said second switching pair (22b) and which outputs the eighth signal at the junction point of the second load block (21b) and said second switching pair (22b), the eighth signal being derived from the multiplication of said second and fourth signals and said fifth and sixth signals.

**10.** The orthogonal demodulation circuit according to claim 9, **characterized in that** said driving stage (23) takes in a ninth signal and controls the ninth signal to vary the gains of said seventh and eighth signals.

**11.** The orthogonal demodulation circuit according to claim 9, **characterized in that** said driving stage (23) comprises a differential pair (34) including two transistors (33).

**12.** The orthogonal demodulation circuit according to claim 9, **characterized in that** said driving stage (23) comprises a differential pair (34) including two transistors (33) and a current source (32).

**13.** The orthogonal demodulation circuit according to claim 9, **characterized in that** said driving stage (23) and said first and second switching pairs (22a, 22b) include bipolar transistors or MOS transistors.

**14.** The orthogonal demodulation circuit according to claim 9, **characterized in that** said first and second load blocks (21b) include passive elements or active elements.

**15.** The orthogonal demodulation circuit according to claim 9, **characterized in that** the pulse width of a waveform of said first signal changes in the opposite manner to the pulse width of a waveform of said second signal, or the pulse width of a waveform of said third signal changes in the opposite manner to the pulse width of a waveform of said fourth signal.

**16.** The orthogonal demodulation circuit according to claim 9, **characterized in that**, if the centers of high-level pulses of said first, second, third, and fourth signals are T1, T2, T3, and T4, respectively, the phase difference between T1 and T2, the phase difference between T2 and T3, and the phase difference between T3 and T4 are kept at 90°.

**17.** The orthogonal demodulation circuit according to claim 9, **characterized in that** said phase shifter (12) includes

a local buffer (13),
a 90° phase shifter (14) which connects to said local buffer (13), and
a waveform shaping circuit (15) which connects to said 90° phase shifter (14).

F I G. 1

F I G. 2

F I G. 3

FIG. 4

11

I_+ I_-

22a

LO1(I_+) →

LO3(I_-) →

First
switching pair

↓

22a

I_+ I_-

LO1 LO3 LO1 LO3

31

LO1(I_+) →

LO3(I_-) →

# FIG. 5

23 34

R1 o → M1 M2 ← o R2

33

↓ 32

23

R1 o → Driving stage ← o R2

23 34

R1 o → M1 M2 ← o R2

33

# FIG. 6

F I G. 7A

F I G. 7B

FIG.8

F I G . 9

F I G. 10

F I G. 11

FIG. 12

FIG. 13

FIG. 14

F I G. 15